# EUROPEAN PATENT APPLICATION

(11) **EP 3 021 073 A2**
(43) Date of publication of application: **18.05.2016**
(21) Application number: 15172673.4
(22) Date of filing: 18.06.2015
(51) Int. Cl.: G01B 11/25, G01N 21/956, G09G 3/32, H01L 51/56

(54) **SURFACE INSPECTION APPARATUS AND METHOD, AND MANUFACTURING METHOD FOR OLED DISPLAYS**

(30) Priority: 11.11.2014 KR 20140156237
(71) Applicant: Samsung Display Co., Ltd., Gyeonggi-do (KR)
(72) Inventor: Kwon, Oh-June, Gyeonggi-do (KR); Ryu, Minho, Gyeonggi-do (KR); Kim, Minjeong, Gyeonggi-Do (KR); Kang, Taewook, Gyeonggi-Do (KR); Song, Seung-Yong, Yongin-City (KR); Yoo, Jeonggeun, Gyeonggi-Do (KR)
(74) Representative: Gulde & Partner

(57) **Abstract**

A surface inspection apparatus and method, and a method of manufacturing a display device are disclosed. In one aspect, the surface inspection method includes placing an object on a stage comprising a top surface inclined at a predetermined angle with respect to a plane having a first direction and a second direction crossing the first direction. The method also includes irradiating light onto the object via a surface inspection unit. The method also includes obtaining a first image comprising first interference fringes captured by the imaging device, moving at least one of the surface inspection unit and the stage in at least one of the first and second directions, obtaining a second image including second interference fringes captured by the imaging device, and moving the surface inspection unit in the third direction so as to correct movement of the second interference fringes with respect to the first interference fringes.

## Description

### BACKGROUND

### Field

The described technology generally relates to a surface inspection apparatus and method.

### Description of the Related Technology

CRT displays have been recently replaced by portable thin flat panel displays. Organic light-emitting diode (OLED) displays are self-emissive and can be driven by low voltages. They are also lightweight and thin, and have wide viewing angles, high contrast, and fast response speeds, thereby being considered a next-generation display technology.

To manufacture a thin and/or flexible OLED display, thin film encapsulation (TFE), including a plurality of inorganic films and organic films to seal an organic emission device, has been recently used.

Research into an inspection apparatus using an interferometer has been conducted so as to precisely measure a shape of a surface having a large area.

### SUMMARY OF CERTAIN INVENTIVE ASPECTS

One inventive aspect is a surface inspection apparatus and method.

Another aspect is a surface inspection method that includes placing an object on a stage including a top surface inclined at a predetermined angle with respect to a plane including a first direction and a second direction that are perpendicular to each other; irradiating light onto the object by using a surface inspection unit including an interferometer having an optical axis aligned in a third direction that is substantially perpendicular to the plane and an imaging device receiving an interference light formed by the interferometer; obtaining a first image including first interference fringes captured by the imaging device; moving the surface inspection unit and/or the stage in the first direction and/or the second direction; obtaining a second image including second interference fringes captured by the imaging device; and moving the surface inspection unit in the third direction to correct movement of the second interference fringes with respect to the first interference fringes.

In some embodiments, a surface inspection method may further include, after placing the object, aligning the surface inspection unit such that a focal point of light irradiated by the surface inspection unit is located on the object.

In some embodiments, a surface inspection method may further include, after obtaining the second image, detecting and storing changes in spaces and/or shapes of the second interference fringes with respect to the first interference fringes; and reconstructing a surface shape of the object corresponding to the changes.

In some embodiments, the top surface of the stage may be inclined from 0.8 degrees to 16 degrees.

In some embodiments, the moving of the surface inspection unit in the third direction to correct movement of the second interference fringes with respect to the first interference fringes may include counting the number of first interference fringes and second interference fringes; and moving the surface inspection unit in the third direction such that the number of second interference fringes is the same as that of the first interference fringes.

In some embodiments, the moving of the surface inspection unit in the third direction may include moving the surface inspection unit in the third direction by using a piezoelectric element.

In some embodiments, the interferometer may include a light source unit for emitting light, a reference mirror, a beam splitter for splitting the light emitted from the light source unit into two lights toward the object and the reference mirror and a focusing lens placed on a path of the light, toward the object, split by the beam splitter, wherein the irradiating of the light comprises: focusing the light emitted from the light source unit on the object by passing through the focusing lens.

In some embodiments, the light source unit may emit a white light.

Another aspect is a method of manufacturing a display device that includes forming an emission device on a substrate; and forming a thin film encapsulation layer on the emission device, wherein the thin film encapsulation layer includes at least one inorganic film and an organic film, and inspecting surface of the inorganic film or a surface of the organic film that are included in the thin film encapsulation layer, wherein the inspecting of the surface of the inorganic film or the surface of the organic film includes placing an object including the emission device and at least a part of the thin film encapsulation layer on a stage including a top surface inclined at a predetermined angle with respect to a plane including a first direction and a second direction that are perpendicular to each other, irradiating light onto the surface of the inorganic film or the surface of the organic film that are included in the thin film encapsulation layer by using a surface inspection unit including an interferometer having an optical axis aligned in a third direction that is substantially perpendicular to the plane and an imaging device receiving an interference light formed by the interferometer, obtaining a first image including first interference fringes captured by the imaging device, moving the surface inspection unit and/or the stage in the first direction and/or the second direction, obtaining a second image including second interference fringes captured by the imaging device; and moving the surface inspection unit in the third direction to correct movement of the second interference fringes with respect to the first interference fringes.

In some embodiments, the forming of the thin film encapsulation layer may include forming a first inorganic film on the emission device, forming a first organic film on the first inorganic film, inspecting a surface of the first organic film, and forming a second inorganic film on the first organic film.

In some embodiments, the forming of the thin film encapsulation layer may further include, after forming the second inorganic film, forming a second organic film on the second inorganic film, inspecting a surface of the second organic film, and forming a third inorganic film on the second organic film.

In some embodiments, the forming of the thin film encapsulation layer may further include, after forming the emission device, forming a capping layer for improving a characteristic of light emitted from the emission device and a cover layer for improving the characteristic of the light emitted from the emission device and protecting the emission device.

In some embodiments, the method of manufacturing a display device may further include forming the thin film encapsulation layer on the emission device, wherein the thin film encapsulation layer includes the at least one inorganic film and the organic film, and inspecting a surface of the thin film encapsulation layer.

In some embodiments, the method of manufacturing a display device may further include, after inspecting the surface of the thin film encapsulation layer, forming a reflection prevention film on the thin film encapsulation layer.

In some embodiments, the method of manufacturing a display device may further include, after placing the object, aligning the surface inspection unit such that a focal point of light irradiated by the surface inspection unit is located on the surface of the inorganic film or the surface of the organic film that are included in the thin film encapsulation layer.

In some embodiments, the method of manufacturing a display device may further include, after obtaining the second image, detecting and storing changes in spaces and/or shapes of the second interference fringes with respect to the first interference fringes; and reconstructing surface shape of the inorganic film or the organic film that are included in the thin film encapsulation layer corresponding to the changes.

In some embodiments, the moving of the surface inspection unit in the third direction to correct movement of the second interference fringes with respect to the first interference fringes may include counting the number of first interference fringes and second interference fringes; and moving the surface inspection unit in the third direction such that the number of second interference fringes is the same as that of the first interference fringes.

Another aspect is a surface inspection apparatus including a stage for supporting an object and including a top surface inclined at a predetermined angle with respect to a plane including a first direction and a second direction that are perpendicular to each other, a surface inspection unit including an interferometer having an optical axis arranged in a third direction that is substantially perpendicular to the plane and an imaging device receiving an interference light, a horizontal driver for moving the surface inspection unit and/or the stage in the first direction and/or the second direction, a perpendicular driver for moving the surface inspection unit in the third direction, and a control unit for controlling the horizontal driver and the perpendicular driver.

In some embodiments, the top surface of the stage may be inclined from about 0.8 degrees to about 16 degrees.

In some embodiments, the imaging device may receive an interference light by moving the surface inspection unit and/or the stage by using the horizontal driver and obtaining images including interference fringes, and wherein the control unit controls the perpendicular driver to correct movement of the interference fringes included in the images and move the surface inspection unit in the third direction.

In some embodiments, the control unit may include a calculating unit for counting the number of interference fringes included in the images.

In some embodiments, the control unit may control the perpendicular driver to maintain the number of interference fringes calculated by the calculation unit constant and move the surface inspection unit in the third direction.

In some embodiments, the perpendicular driver may include a piezoelectric element.

In some embodiments, the interferometer may include a light source unit for emitting light, a reference mirror, a beam splitter for splitting the light emitted from the light source unit into two lights toward the object and the reference mirror, and a focusing lens placed on a path of the light, toward the object, split by the beam splitter wherein the irradiating of the light includes focusing the light emitted from the light source unit on the object by passing through the focusing lens.

In some embodiments, the light source unit may emit a white light.

Another aspect is a surface inspection method for a display device, the method comprising placing an object on a stage comprising a top surface inclined at a predetermined angle with respect to a plane having a first direction and a second direction crossing the first direction. The method also comprises irradiating light onto the object via a surface inspection unit including i) an interferometer having an optical axis aligned in a third direction crossing the plane and ii) an imaging device receiving an interference light formed by the interferometer. The method further comprises obtaining a first image comprising first interference fringes captured by the imaging device, moving at least one of the surface inspection unit and the stage in at least one of the first and second directions, obtaining a second image comprising second interference fringes captured by the imaging device, and moving the surface inspection unit in the third direction so as to correct movement of the second interference fringes with respect to the first interference fringes.

The above method may further comprise, after placing the object, aligning the surface inspection unit such that a focal point of the irradiated light is located on the object.

The above method may further comprise, after obtaining the second image, detecting and storing changes in at least one of spaces and shapes of the second interference fringes with respect to the first interference fringes and reconstructing a surface shape of the object corresponding to the changes.

In the above method, the top surface of the stage may be inclined from about 0.8 degrees to about 16 degrees with respect to the plane.

In the above method, the moving may comprise counting the number of the first and second interference fringes and moving the surface inspection unit in the third direction such that the number of the second interference fringes is the same as that of the first interference fringes.

In the above method, the moving may comprise moving the surface inspection unit in the third direction with a piezoelectric element.

In the above method, the interferometer may comprise a light source configured to emit light, a reference mirror and a beam splitter configured to split the emitted light into first light to be directed towards the object and second light to be directed towards the reference mirror. The interferometer also comprises a focusing lens placed on a path of the first light, wherein the irradiating comprises focusing the emitted light on the object.

In the above method, the light source may be configured to emit white light.

Another aspect is a method of manufacturing a display device, the method comprising forming an emission device on a substrate, forming a thin film encapsulation layer over the emission device, wherein the thin film encapsulation layer comprises at least one inorganic film and at least one organic film, and inspecting a surface of the inorganic film or a surface of the organic film. The inspecting comprises placing an object comprising the emission device and at least a portion of the thin film encapsulation layer on a stage having a top surface inclined at a predetermined angle with respect to a plane having a first direction and a second direction crossing the first direction. The inspecting also comprises irradiating light onto the surface of the inorganic film or the surface of the organic film using a surface inspection unit including i) an interferometer having an optical axis aligned in a third direction crossing the plane and ii) an imaging device receiving an interference light from the interferometer. The inspecting also comprises obtaining a first image comprising first interference fringes captured by the imaging device, moving at least one of the surface inspection unit and the stage in at least one of the first and the second directions, obtaining a second image comprising second interference fringes captured by the imaging device, and moving the surface inspection unit in the third direction so as to correct movement of the second interference fringes with respect to the first interference fringes.

In the above method, the forming of the thin film encapsulation layer may comprise forming a first inorganic film over the emission device, forming a first organic film over the first inorganic film, inspecting a surface of the first organic film, and forming a second inorganic film over the first organic film.

In the above method, the forming of the thin film encapsulation layer may further comprise, after forming the second inorganic film, forming a second organic film over the second inorganic film, inspecting a surface of the second organic film, and forming a third inorganic film over the second organic film.

The above method may further comprise, after forming the emission device, forming a capping layer, so as to improve a characteristic of light emitted from the emission device, and a cover layer, so as to further improve the characteristic and protect the emission device.

The above method may further comprise forming the thin film encapsulation layer over the emission device, wherein the thin film encapsulation layer comprises the at least one inorganic film and the organic film, and inspecting a surface of the thin film encapsulation layer.

The above method may further comprise, after inspecting the surface of the thin film encapsulation layer, forming a reflection prevention film over the thin film encapsulation layer.

The above method may further comprise, after placing the object, aligning the surface inspection unit such that a focal point of the irradiated light is located on the surface of the inorganic film or the surface of the organic film.

The above method may further comprise, after obtaining the second image, detecting and storing changes in at least one of spaces and shapes of the second interference fringes with respect to the first interference fringes, and reconstructing a surface shape of the inorganic film or the organic film corresponding to the changes.

In the above method, the moving of the surface inspection unit may comprise counting the number of the first and second interference fringes and moving the surface inspection unit in the third direction such that the number of the second interference fringes is the same as that of the first interference fringes.

Another aspect is a surface inspection apparatus for a display device, comprising a stage configured to support an object and having a top surface inclined at a predetermined angle with respect to a plane having a first direction and a second direction crossing the first direction. The apparatus also comprises a surface inspection unit comprising i) an interferometer having an optical axis aligned in a third direction crossing the plane and configured to emit interference light and ii) an imaging device configured to receive the interference light from the interferometer. The apparatus further comprises a horizontal driver configured to move at least one of the surface inspection unit and the stage in at least one of the first and second directions. The apparatus also comprises a perpendicular driver configured to move the surface inspection unit in the third direction and a controller configured to control the horizontal driver and the perpendicular driver.

In the above apparatus, the top surface may be inclined from about 0.8 degrees to about 16 degrees with respect to the plane.

In the above apparatus, the imaging device may be further configured to move at least one of the surface inspection unit and the stage with the use of the horizontal driver and obtain images including interference fringes, wherein the controller is further configured to control the perpendicular driver to correct movement of the interference fringes and move the surface inspection unit in the third direction.

In the above apparatus, the controller may comprise a calculator configured to count the number of interference fringes included in the images.

In the above apparatus, the controller may be further configured to control the perpendicular driver to maintain the number of the calculated interference fringes to be substantially constant and move the surface inspection unit in the third direction.

In the above apparatus, the perpendicular driver may comprise a piezoelectric element.

In the above apparatus, the interferometer may comprise a light source configured to emit light, a reference mirror, and a beam splitter configured to split the emitted light into first light to be directed towards the object and second light to be directed towards the reference mirror. In the above apparatus, the interferometer also comprises a focusing lens placed on a path of the first light and configured to focus the emitted light.

In the above apparatus, the light source may be configured to emit white light.

### BRIEF DESCRIPTION OF THE DRAWINGS

FIG. 1 is a schematic diagram of a configuration of a surface inspection apparatus according to an embodiment.
FIG. 2 is a schematic diagram of a configuration of a surface inspection unit of FIG. 1.
FIG. 3 is a flowchart sequentially showing a surface inspection method according to an embodiment.
FIG. 4 is a flowchart of an example of the operation S170 of FIG. 3.
FIG. 5A is a schematic configuration diagram of positions of a surface inspection unit corresponding to the operations of FIG. 4.
FIG. 5B is a diagram of interference fringes obtained at positions POS1, POS2, and POS3 of FIG. 5A according to an embodiment.
FIG. 6 is a diagram of changes in interference fringes when a surface of an object includes a curve according to an embodiment.
FIG. 7 is a flowchart sequentially showing a method of manufacturing a display device, according to an embodiment.
FIG. 8 is a schematic cross-sectional view of a display device manufactured by using the method of manufacturing the display device of FIG. 7, according to an embodiment.
FIG. 9 is a flowchart sequentially showing a method of manufacturing a display device, according to another embodiment.
FIG. 10 is a schematic cross-sectional view of a display device manufactured by using the method of manufacturing the display device of FIG. 8, according to another embodiment.
FIG. 11 is a flowchart sequentially showing a method of manufacturing a display device, according to another embodiment.
FIG. 12 is a schematic cross-sectional view of the display device manufactured by using the method of manufacturing the display device of FIG. 11, according to another embodiment.

### DETAILED DESCRIPTION OF CERTAIN INVENTIVE EMBODIMENTS

Reference will now be made in detail to embodiments, examples of which are illustrated in the accompanying drawings. In this regard, the present embodiments can have different forms and should not be construed as being limited to the descriptions set forth herein. Accordingly, the embodiments are merely described below, by referring to the figures, to explain aspects of the present description.

In drawings, like reference numerals refer to like elements throughout and overlapping descriptions shall not be repeated.

It will be understood that although the terms "first", "second", etc. can be used herein to describe various components, these components should not be limited by these terms. These components are only used to distinguish one component from another.

As used herein, the singular forms "a," "an", and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, area, or component is referred to as being "formed on," another layer, area, or component, it can be directly or indirectly formed on the other layer, area, or component. That is, for example, intervening layers, areas, or components can be present.

Sizes of elements in the drawings can be exaggerated for convenience of explanation. In other words, since sizes and thicknesses of components in the drawings are arbitrarily illustrated for convenience of explanation, the following embodiments are not limited thereto.

In the following examples, the x-axis, the y-axis, and the z-axis are not limited to the three axes of the rectangular coordinate system, and can be interpreted in a broader sense. For example, the x-axis, the y-axis, and the z-axis can be perpendicular to one another, or can represent different directions that are not perpendicular to one another.

As used herein, the term "and/or" includes any and all combinations of one or more of the associated listed items.

Hereinafter, one or more exemplary embodiments will be described in detail with reference to accompanying drawings. In this disclosure, the term "substantially" includes the meanings of completely, almost completely or to any significant degree under some applications and in accordance with those skilled in the art. Moreover, "formed on" can also mean "formed over." The term "connected" can include an electrical connection.

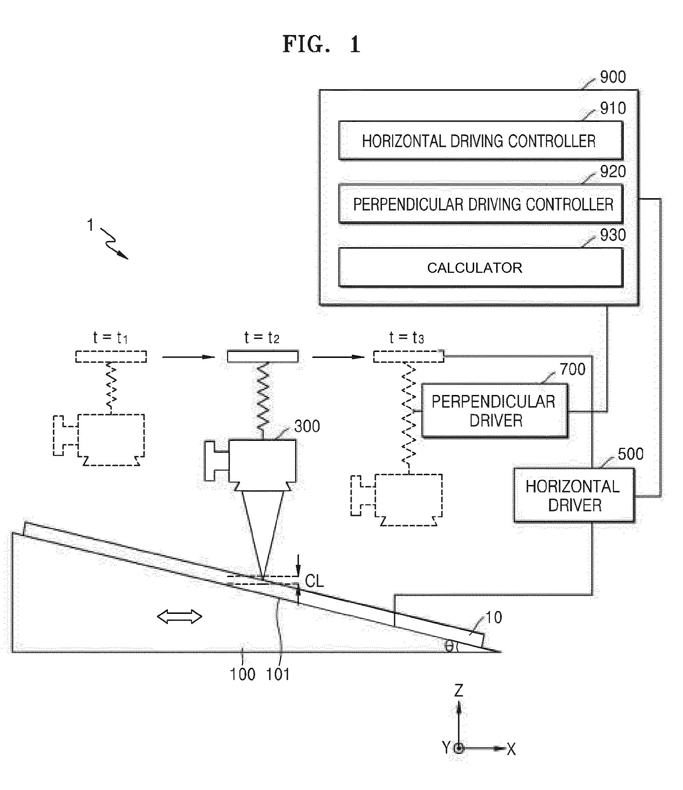

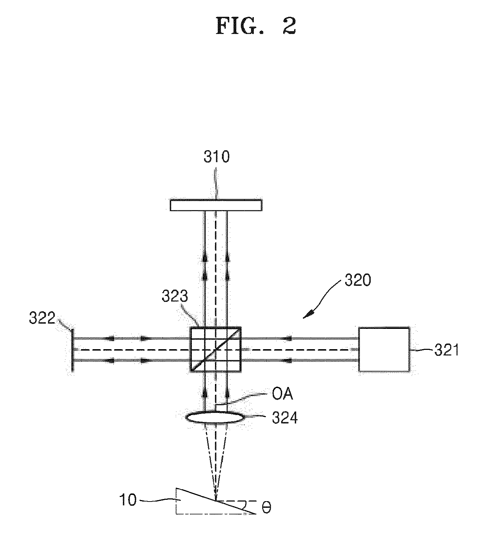

FIG. 1 is a schematic diagram of a configuration of a surface inspection apparatus 1 according to an embodiment. FIG. 2 is a schematic diagram of a configuration of a surface inspection unit of FIG. 1.

Referring to FIGS. 1 and 2, the surface inspection apparatus 1 according to an embodiment includes a stage 100 supporting an object 10 and including a top surface 101 inclined at a predetermined angle θ with respect to a plane including a first direction X and a second direction Y that are substantially perpendicular to each other. The surface inspection apparatus 1 also includes a surface inspection unit 300 including an interferometer 320 having an optical axis OA aligned in a third direction Z that is substantially perpendicular to the plane and an imaging device 310 receiving an interference light. The surface inspection apparatus 1 also includes a horizontal driver 500 moving the surface inspection unit 300 and/or the stage 100 in the first direction X and/or the second direction Y. The surface inspection apparatus 1 further includes a perpendicular driver 700 moving the surface inspection unit 300 in the third direction Z. The surface inspection apparatus 1 also includes a control unit or controller 900 controlling the horizontal driver 500 and the perpendicular driver 700.

The surface inspection unit 300 can measure a shape of a surface of the object 10 placed on the stage 100 by the interferometer 320 in a non-contact way. Since the top surface 101 of the stage 100 is inclined to the plane, even when a surface of the object 10 placed on the stage 100 is substantially flat, an image captured by the imaging device 10 receiving the interference light formed by the interferometer 320 can include interference fringes placed at a predetermined space.

The interferometer 320 can include a light source unit or light source 321 emitting light, a reference mirror 322, a beam splitter 323 splitting the light emitted from the light source unit 321 into two lights toward the object 10 and the reference mirror 322, and a focusing lens 324 placed on a path of the light, toward the object 10, split by the beam splitter 323 and focusing the light on the object 10.

Although not shown, the light source unit 321 can include a light source (not shown) emitting light and a collimator (not shown) converting the light emitted by the light source into a parallel light. An image forming optical system (not shown) forming light on the imaging device 310 can be placed on a front surface of the imaging device 310.

The light source unit 321 can emit a white light. The white light can have a coherence length of about 900 nm. That is, a position of the surface of the object 10 that can be measured by the surface inspection unit 300 in the third direction Z can be limited within a predetermined range CL.

The top surface 101 of the stage 100 is inclined as the predetermined angle θ with respect to the plane including the first direction X and the second direction Y. According to an embodiment, the angle θ can be in the range from about 0.8 degrees to about 16 degrees.

The angle θ can differentiate spaces between the interference fringes, i.e., an area of a part occupied by the interference fringes within a capturing range of the imaging device 310. When the angle θ is less than about 0.8 degrees, since the spaces between the interference fringes greatly increases, the area of the part occupied by the interference fringes can be greater than the capturing range. In some embodiments, when the angle θ is greater than about 16 degrees, since the area of the part occupied by the interference fringes greatly decreases, the interference fringes is not clearly discriminated due to a limit of a resolution of the imaging device 310.

The light emitted by the light source unit 321 can split into two by the beam splitter 323 such that the two lights can travel toward the object 10 and the reference mirror 322, respectively. The light split by the beam splitter 323 and traveling toward the object 10 can be focused on the object 10 by the focusing lens 324. The light reflected by the object 10 can pass through the focusing lens 324 and the beam splitter 323 and overlap with the light reflected by the reference mirror 322, and thus an interference light can be formed and can be incident to the imaging device 310.

A numerical aperture (NA) of the focusing lens 324 can be equal to or greater than about 0.25. That is, although a path of the light incident to the object 10 and a path of the light reflected by the object 10 is not the same due to the inclined surface of the object 10, if the difference in the path between the incident light and the reflected light belongs to a range, for example, within about 30 degrees, the reflected light can be incident to the collimating lens 324 again and can be received by the imaging device 310.

The interferometer of FIG. 2 is an example, and the described technology is not limited thereto. That is, the interferometer according to another embodiment can have various shapes such as a Michelson interferometer, a Mach-Zehnder interferometer, or a Sagnac interferometer, in addition to a Gwyman-Green interferometer.

The object 10 can have a large area, and can measure a surface shape of the entire surface of the object 10 by moving the stage 10 and/or the surface inspection unit 300 in the first direction X and/or the second direction Y.

The symbol t of FIG. 1 denotes a time at which measuring is performed. The symbols t₁, t₂, and t₃ denote different times at which measuring is performed by relatively moving the stage 100 and the surface inspection unit 300. FIG. 1 shows a relative location of the surface inspection unit 300 with respect to the stage 100 at each of the times t₁, t₂, and t₃.

Since the top surface 101 is inclined to the plane, when the horizontal driver 500 moves the stage 100 and the surface inspection unit 300 in the first direction X and/or the second direction Y, a distance between the surface inspection unit 300 and the object 10 can be different. Thus a height of the object 10 can go beyond a range of the coherence length that can be measured by the surface inspection unit 300.

Although only the object 10 can move and the stage 100 and the surface inspection unit 300 are fixed such that the position of the object 10 is always placed within the coherence length, an error factor such as vibration can occur when the object 10 moves along the inclined top surface 101.

A non-contact surface inspection apparatus 1 using an interferometer can measure unevenness of several and several tens of nm formed on a surface. When irregular vibration occurs due to a movement of the object 10, an error beyond an allowable range can occur. Thus, the surface inspection apparatus 1 according to an embodiment inspects the entire surface of the object 10 by relatively moving the stage 100 and the object 10 while the object 10 is fixed to the stage 100.

The surface inspection apparatus 1 according to an embodiment includes the perpendicular driver 700 that can move the surface inspection unit 300 in the third direction Z and can move the surface inspection unit 300 in the third direction Z by using the perpendicular driver 700 so as to correct an axial movement of the interference fringes continuously captured by the imaging device 310. The perpendicular driver 700 can include a piezoelectric element to enable a fine perpendicular movement but is not limited thereto. Here, the surface inspection unit 300 can be moved in the third direction Z with the piezoelectric element.

That is, to inspect the entire surface of the object 10, the surface inspection unit 300 and/or the stages 100 can move in the first direction X and/or the second direction Y, compare a captured interference fringe with a previous interference fringe, and receive feedback of a comparison value to move the surface inspection unit 300 in the third direction Z according to a movement value corresponding to the comparison value.

The position of the surface inspection unit 300 in the third direction Z can be continuously changed according to a height change of the surface of the object 10 while inspecting the entire surface of the object 10, and thus a captured area of the object 10 can always be positioned within the coherence length range. The height change of the surface of the object 10 can occur according to not only an inclination of the top surface 101 of the stage 100 but also a protrusion unit and a sunken unit formed on the surface of the object 10.

The surface inspection apparatus 1 according to an embodiment includes the control unit 900 including a horizontal driving control unit or horizontal driving controller 910 and a perpendicular driving control unit or perpendicular driving controller 920 that control the horizontal driver 500 and the perpendicular driver 700, respectively. The control unit 900 can further include a calculation unit or calculator 930 counting the number of interference fringes included in images captured by the imaging device 310.

The calculation unit 930 can count the number of interference fringes included in the captured images by relatively moving the surface inspection unit 300 with respect to the stage 100 and continuously provide feedback. There is an allowed predetermined value of the number of interference fringes allowed during inspection, such that when this number is exceeded, the perpendicular driver 700 can adjust the position of the surface inspection unit 300 in the third direction Z.

The surface inspection apparatus 1 according to an embodiment described above precisely measures a shape of entire surfaces of the object 10 having a wide area.

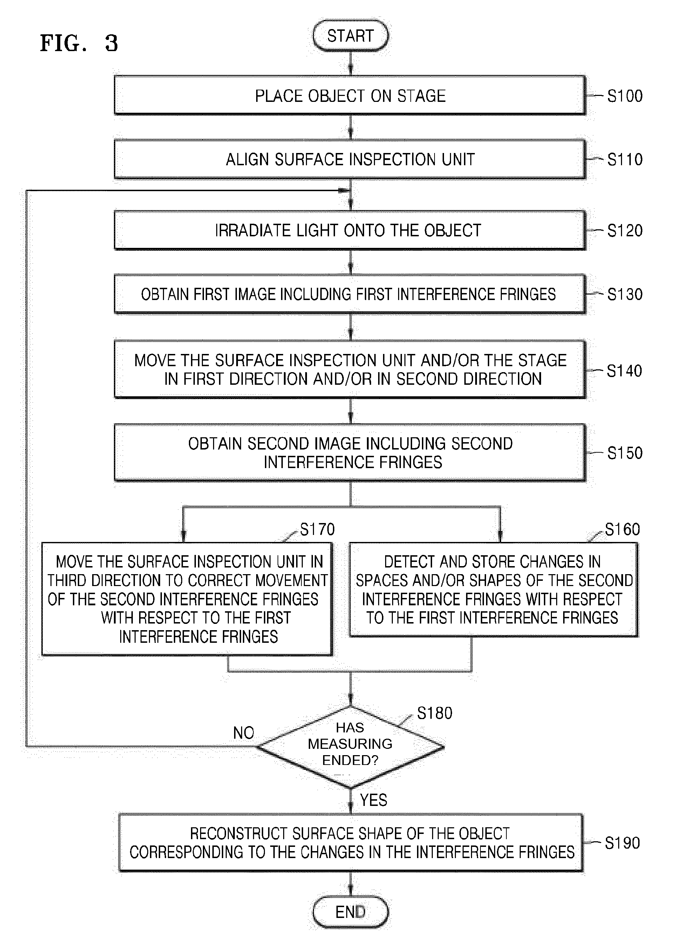

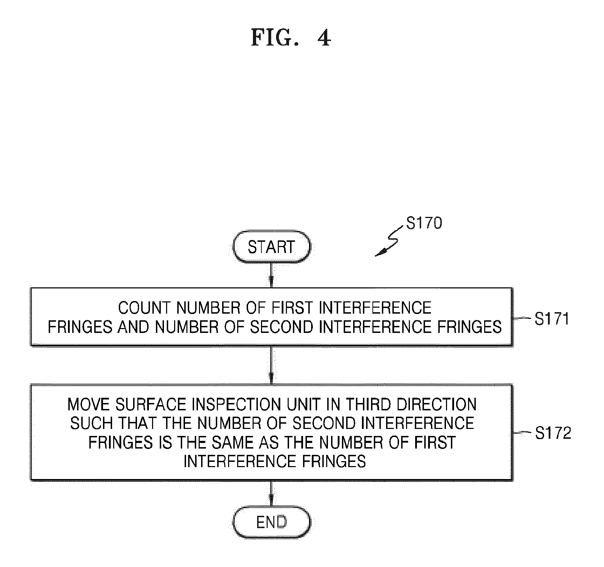

FIG. 3 is a flowchart sequentially showing a surface inspection method according to an embodiment. FIG. 4 is a flowchart of an example of the operation S180 of FIG. 3. The surface inspection method according to an embodiment will now be described by using reference numerals indicated in the surface inspection apparatus 1 of FIGS. 1 and 2. Depending on the embodiment, additional states can be added, others removed, or the order of the states changed in FIG. 3.

Referring to FIGS. 3 and 4, the surface inspection method according to an embodiment includes an operation S100 of placing the object 10 on the stage 100 including the top surface 101 inclined at the predetermined angle θ with respect to a plane including the first direction X and the second direction Y that are substantially perpendicular to each other. The method also includes an operation S120 of irradiating light onto the object 10 by using the surface inspection unit 300 including the interferometer 320 having the optical axis OA arranged in the third direction Z that is substantially perpendicular to the plane and the imaging device 310 receiving an interference light. The method further includes an operation S130 of obtaining a first image including first interference fringes captured by the imaging device 310 and an operation S140 of moving the surface inspection unit 300 and/or the stage 100 in the first direction X and/or the second direction Y. The method also includes an operation S150 of obtaining a second image including second interference fringes captured by the imaging device 310 and an operation S170 of moving the surface inspection unit 300 in the third direction Z to correct movement of the second interference fringes with respect to the first interference fringes.

The interferometer 320 can include the light source unit 321 emitting light, the reference mirror 322, the beam splitter 323 splitting the light emitted from the light source unit 321 into two lights toward the object 10 and the reference mirror 322, and the focusing lens 324 placed on a path of the light, toward the object 10, split by the beam splitter 323 and focusing the light on the object 10.

The object 10 can be placed on the stage 100 such that a surface of the object 10 that is to be measured can be facing the surface inspection unit 300. If the object 10 has substantially the same thickness as a whole, a top surface of the object 10 can be positioned such that the top surface can be inclined at the same angle θ as the top surface 101 of the stage 100 is inclined with respect to the plane including the first direction X and the second direction Y.

The object 10 can substantially include a major surface inclined at the predetermined angle θ and can have various shapes of protruding or sunken surfaces with respect to the major surface.

According to an embodiment, the surface inspection method further includes an operation S110 of aligning the surface inspection unit 300 such that a focal point of the light irradiated by the surface inspection unit 300 can be located on the surface of the object 10, after the operation S100 of placing the object 10 is performed.

That is, the surface of the object 10 that is to be measured can be placed within a range that can be measured by the surface inspection unit 300, i.e., within a coherence length that can be a position corresponding to a focal position of the focusing lens 324 included in the surface inspection unit 300. Thus, the position of the surface inspection unit 300 in the third direction Z is adjusted, thereby aligning the surface inspection unit 300 such that the object 10 can be positioned in the focal point of the light irradiated by the surface inspection unit 300.

Light can be irradiated onto the object 10 by using the surface inspection unit 300 after the surface inspection unit 300 is aligned. The light reflected from the surface of the object 10 and the light reflected by the reference mirror 322 can overlap with each other, and thus, an interference light can be formed and can be incident to the imaging device 310.

That is, the first image captured by the imaging device 310 can include the first interference fringes corresponding to a surface shape of the object 10. When the surface of the object 10 is substantially flat, the first interference fringes can be substantially parallel to each other by a predetermined space. An area of the first interference fringes occupied in the first image can differ according to the coherence length and the inclined angle θ.

After the operation S130 of obtaining the first image is performed, an operation S140 of moving the surface inspection unit 300 and/or the stage 100 in the first direction X and/or the second direction Y can be performed so as to inspect an entire surface of the object 10.

Only one of the surface inspection unit 300 and the stage 100 or both of them can move. That is, the surface inspection unit 300 and the stage 100 can relatively move. The surface inspection unit 300 and the stage 100 can freely move within the plane including the first direction X and the second direction Y by the horizontal driver 500 controlled by the horizontal driving control unit 910 included in the control unit 900. Data regarding the movement in a horizontal direction can be stored in a memory (not shown) and can be used when a shape of the surface of the object 10 is reconstructed.

After the operation S140 of moving the surface inspection unit 300 and/or stage 100 is performed, an operation S150 of obtaining the second image including the second interference fringes captured by the imaging device 310 can be performed. Although an operation of irradiating light onto the object 10 from the surface inspection unit 300 can be performed so as to obtain the second image, the surface inspection unit 300 can continuously irradiate the light during the inspection, and the imaging device 310 can continuously perform capturing by moving the surface inspection unit 300 and/or the stage 100.

When the surface of the object 10 is substantially flat, the second interference fringes can only shift in a direction while the second interference fringes can have substantially the same shape as the first interference fringes. That is, interference images can be observed only in an area of the object 10 placed in a position corresponding to the coherence length, and the position of the area corresponding to the coherence length can move axially within an image by the movement of the surface inspection unit 300 and/or the stage 100. When the coherence length is extremely long, in spite of the movement of the surface inspection unit 300 and/or the stage 100, since interference fringes can be continuously observed throughout a captured image, it can be difficult to detect an axial movement amount.

Therefore, the light source unit 321 included in the interferometer 320 according to an embodiment emits a white light having the coherence length of about 900 nm, and the stage 100 has the angle θ from about 0.8 degrees to about 16 degrees inclined with respect to the plane.

After the operation S150 of obtaining the second image is performed, the operation S170 of moving the surface inspection unit 300 in the third direction Z to correct movement of the second interference fringes with respect to the first interference fringes can be performed.

As described above, when the surface of the object 10 is flat, the second interference fringes can only shift in a direction while the second interference fringes can have substantially the same shape with the first interference fringes. When the surface inspection unit 300 and/or the stage 100 further move, since the interference fringes totally disappear from the image, a surface measurement can be impossible with respect to the entire surface of the object 10. Thus, the surface inspection unit 300 can move in the third direction Z to correct the movement of the second interference fringes with respect to the first interference fringes. The surface inspection unit 300 can move by the perpendicular driver 700. According to an embodiment, the perpendicular driver 700 can include a piezoelectric element. A movement amount of the surface inspection unit 300 can be controlled by the driving control unit 920 included in the control unit 900.

According to an embodiment, the operation S180 of moving the surface inspection unit 300 in the third direction Z includes an operation S171 of counting the number of first interference fringes and second interference fringes and an operation S172 of moving the surface inspection unit 300 in the third direction Z such that the number of second interference fringes can be the same as that of the first interference fringes.

When the surface inspection unit 300 and/or the stage 100 move, the position of the area corresponding to the coherence length of the object 10 can move axially within the image, and the number of interferences fringes included in the image can be reduced by the movement. Thus, when the number of second interferences fringes is less than that of the first interference fringes, the surface inspection unit 300 can move in the third direction Z, and thus the number of interference fringes included in the image can be the same as that of the first interference fringes.

When the surface of the object 10 is not flat, spaces and/or shapes of the second interference fringes can be modified from spaces and/or shapes of the first interference fringes. For example, when the surface of the object 10 has a protruding unit or a sunken unit, the surface inclination differs, which changes spaces of the interference fringes, and thus shapes of the interference fringes can be distorted according to a shape of the protruding unit or the sunken unit.

According to an embodiment, the surface inspection method includes an operation S160 of detecting changes in the spaces and/or shapes of the second interference fringes with respect to the first interference fringes and storing the changes in a memory (not shown).

The changes in the spaces and/or the shapes can occur substantially simultaneously with the axial movement of the interference fringes by an inclination of the major surface of the object 10. Thus, the operation S170 of moving the surface inspection unit 300 in the third direction Z to correct the axial movement and the operation S160 of detecting and storing the changes in the spaces and/or the shapes can be substantially simultaneously performed.

After the operations S160 and S170 are performed, and the operation S180 of determining whether the measurement completely ends can be performed, when the measurement completely ends, an operation S190 of reconstructing the surface shape of the object 10 corresponding to the changes in the interference fringes can be performed. The shape can be reconstructed by matching coordinates of the first direction X and the second direction Y stored in the memory (not shown) and data of the changes in the interference fringes corresponding to the coordinates.

When the measurement does not completely end, the operation S120 of irradiating the light onto the object 10 and the operation S130 of obtaining the first image including the first interference fringes can be performed again. The first image can be an image obtained at a position where the surface inspection unit 300 is corrected with respect to the third direction Z. After the operation S130 of obtaining the first image is performed, the operations S140-S170 can be performed again. That is, the operations S120 through S170 can be repeatedly performed until the measurement completely ends.

The surface inspection method according to an embodiment described above precisely measures a shape of an entire surface of the object 10 having a wide area.

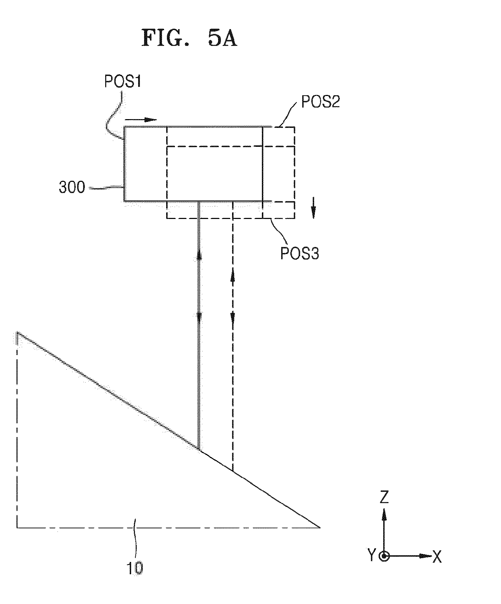

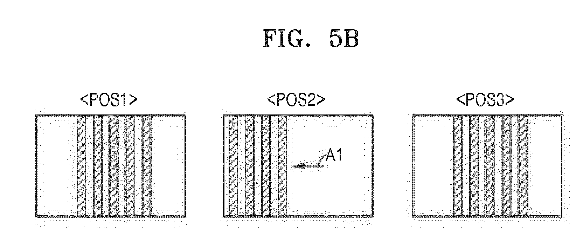

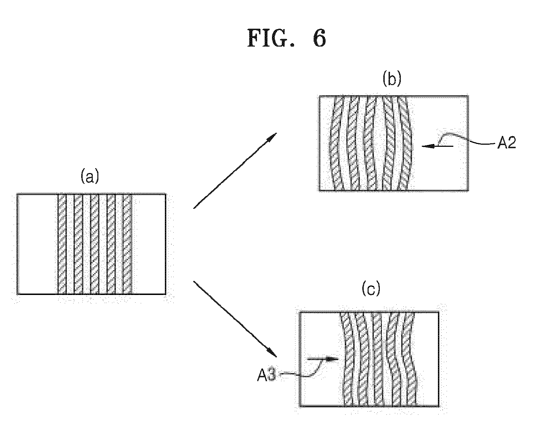

FIG. 5A is a schematic configuration diagram of positions POS1, POS2, and POS3 of the surface inspection unit 300 corresponding to the operations of FIG. 4. FIG. 5B is a diagram of interference fringes obtained at the positions POS1, POS2, and POS3 of FIG. 5A according to an embodiment. FIGS. 6 is a diagram of changes in interference fringes when a surface of the object 10 includes a curve according to an embodiment.

Referring to FIGS. 5A and 5B, when the surface inspection unit 300 included in a surface inspection apparatus according to an embodiment is at the first position POS1, first interference fringes included in a first image captured by the imaging device 310 can have a shape as shown in <POS1> of FIG. 5B. A position of the surface inspection unit 300 can be determined in the operations S110 through S130 of FIG. 4.

The surface inspection unit 300 can move from the first position POS1 to the second position POS2 through the operation S140 of FIG. 4. Second interference fringes included in a second image captured by the imaging device 310 at the second position POS2 can have a shape as shown in <POS2> of FIG. 5B. <POS2> of FIG. 5B can have a shape moving in an arrow direction A1 without a change in a shape of an interference fringe with respect to <POS1>.

The operation S170 of FIG. 4 is performed so as to correct the movement, and thus the surface inspection unit 300 can move to the third position POS3, and an image captured by the imaging device 310 at the third position POS3 can have a shape as shown in <POS3> of FIG. 5B.

The image captured at the third position POS3 as described above can be provided as a first image including first interference fringes again. The operation S140 of moving the surface inspection unit 300 with respect to the third position POS3 and obtaining a second image including second interference fringes can be performed. The operations can be repeatedly performed until a surface inspection on an entire surface of the object 10 having a wide area ends.

Referring to FIG. 6, when a surface of the object 10 has a defect such as a protruding unit or a sunken unit, spaces and shapes of interference fringes can be modified as shown in (a), (b) and (c) in FIG. 6. The modifications of the spaces and the shapes of interference fringes can occur along with axial movement on an image in arrow directions A2 and A3 indicated by a movement of the surface inspection unit 300 and/or the stage 100 in the first direction X and/or the second direction Y.

In this case, after changes in the spaces and the shapes are detected and stored, and then the measuring ends, a surface shape of the object 10 corresponding to the changes can be reconstructed, and the axial movement can be corrected by moving the surface inspection unit 300 in the third direction Z.

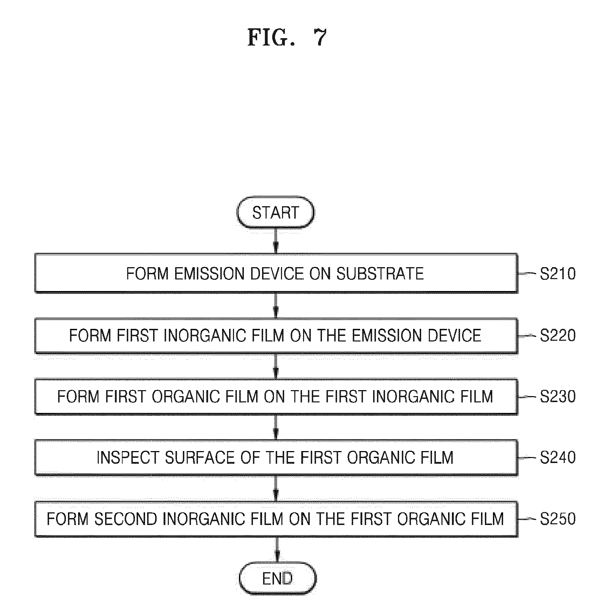

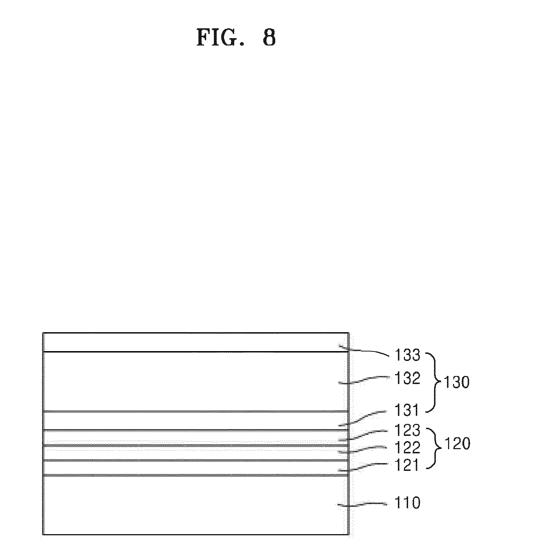

FIG. 7 is a flowchart sequentially showing a method of manufacturing a display device according to an embodiment. FIG. 8 is a schematic cross-sectional view of the display device manufactured by using the method of manufacturing the display device of FIG. 7 according to an embodiment. Depending on the embodiment, additional states can be added, others removed, or the order of the states changed in FIG. 7.

Referring to FIGS. 7 and 8, the method of manufacturing the display device according to an embodiment includes an operation S210 of forming an emission device 120 on a substrate 110, and an operation of forming a thin film encapsulation layer 130 on the emission device 120. The thin film encapsulation layer 130 includes at least one of inorganic films 131 and 133 and an organic film 132, and inspecting surfaces of the inorganic films 131 and 133 or a surface of the organic film 132 that are included in the thin film encapsulation layer 130.

According to an embodiment, the operation of forming the thin film encapsulation layer 130 and inspecting the surfaces of the inorganic films 131 and 133 or the surface of the organic film 132 includes an operation S220 of forming the first inorganic film 131 on the emission device 120. The operation also includes an operation S230 of forming the first organic film 132 on the first inorganic film 131, an operation S240 of inspecting the surface of the first organic film 132, and an operation S250 of forming the second inorganic film 133 on the first organic film 132.

The substrate 110 can be a flexible plastic substrate. The emission device 120 can be an organic light emission device including a first electrode 121, a second electrode 123, and an organic emission layer 122 formed between the first electrode 121 and the second electrode 123 and emitting light but is not limited thereto. That is, the substrate 110 can be a rigid substrate formed of glass, and the emission device 120 can be a device having various types and emitting the light.

A sealing member is necessary for protecting the emission device 120 from external moisture or oxygen. According to an embodiment, the sealing member can include the thin film encapsulation layer 130 including flexible thin films. The thin film encapsulation layer 130 can include the at least one of inorganic films 131 and 133, and at least one of the organic film 132.

According to an embodiment, the first inorganic film 131 formed on the emission device 120 includes a single layer or a multiple layer formed of SiNₓ, SiO₂, SiOₓN_{y}, or Al₂O₃. The first inorganic film 131 can be formed by using sputtering or chemical vapor deposition (CVD).

After the operation S220 of forming the first inorganic film 131 is performed, an operation S230 of forming the first organic film 132 on the first inorganic film 131 can be performed. According to an embodiment, the first organic film 132 includes various types of organic materials such as epoxy based resin, acryl based resin, or polyimide based resin, etc.

The first organic film 132, along with the first inorganic film 131, can block or reduce penetration of impurities such as moisture or oxygen into the emission device 120. The first organic film 132 can have a substantially flat top surface. However, due to various factors that can occur during a process, an undesired defect such as a protruding unit and/or a sunken unit can be formed in the top surface of the first organic film 132. When a height or depth of a protruding or sunken unit is extremely large, the protruding or sunken unit can be a defect of the display device.

Therefore, after the thin film encapsulation layer 130 is formed in the display device, before a subsequent process of attaching a polarizer (not shown) is performed, it can be necessary to measure the thin film encapsulation layer 130, in particular, a surface shape of the organic film 132 included in the thin film encapsulation layer 130 and determine whether the defect occurs.

After the operation S230 of forming the first organic film 132 is performed, the operation S240 of inspecting the surface of the first organic film 132 can be performed. The operation S240 can include operations S100 through S190 of FIGS. 3 and 4.

Referring to FIGS. 1 through 3, the operation S240 of inspecting the surface of the first organic film 132 includes the operation S100 of placing the object 10 on which the emission device 120, the first inorganic film 131, and the first organic film 132 are formed on the stage 100 including the top surface 101 inclined at the predetermined angle θ with respect to a plane including the first direction X and the second direction Y that are substantially perpendicular to each other. The operation S240 also includes the operation S120 of irradiating light onto a surface of the first organic film 132 by using the surface inspection unit 300 including the interferometer 320 having the optical axis OA aligned in the third direction Z that is substantially perpendicular to the plane and the imaging device 310 receiving an interference light formed by the interferometer 320. The operation S240 further includes the operation S130 of obtaining a first image including first interference fringes captured by the imaging device 310, the operation S140 of moving the surface inspection unit 300 and/or the stage 100 in the first direction X and/or the second direction Y, and the operation S150 of obtaining a second image including second interference fringes captured by the imaging device 310 The operation S240 also includes the operation S170 of moving the surface inspection unit 300 in the third direction Z to correct movement of the second interference fringes with respect to the first interference fringes.

After the operation S100, the operation S240 can further include the operation S110 of aligning the surface inspection unit 300 such that a focal point of the light irradiated by the surface inspection unit 300 can be placed in the surface of the first organic film 132. After the operation S150, the operation S240 can further include the operation S160 of detecting changes in spaces and/or shapes of the second interference fringes with respect to the first interference fringes and storing the changes and the operation S190 of reconstructing a surface shape of the first organic film 132 corresponding to the changes.

The operations of inspecting surfaces included in the operations of the method of manufacturing the display device according to an embodiment are the same as those of FIGS. 3 and 4, and thus detailed descriptions thereof are omitted.

After the operation S240 of inspecting the surface of the first organic film 132 is performed, the operation S250 of forming the second inorganic film 133 on the first organic film 132 can be performed. According to an embodiment, the second inorganic film 133 include a single layer formed of SiNₓ, SiO₂, or SiOₓN_{y}.

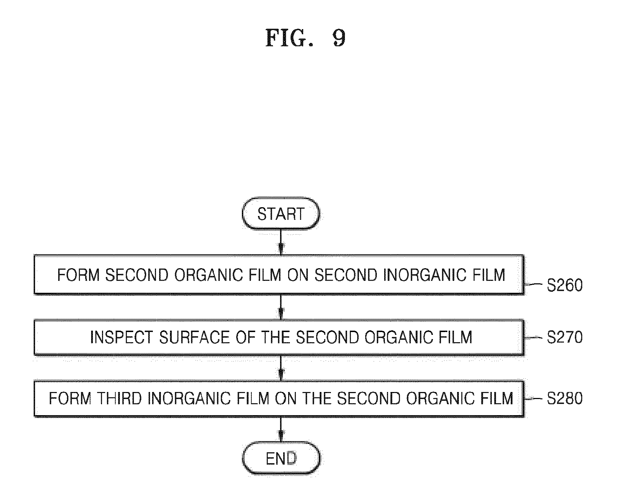

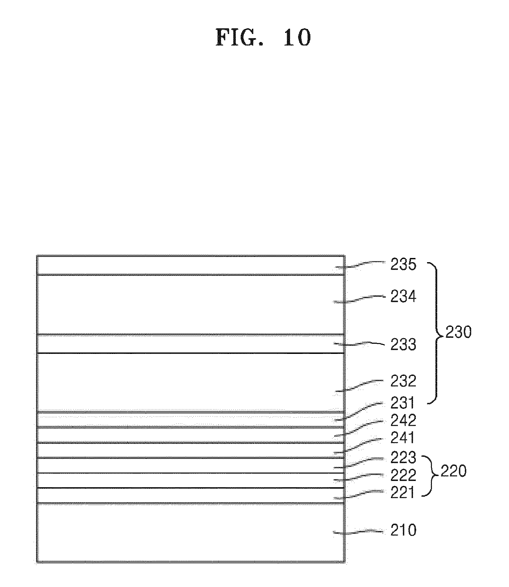

FIG. 9 is a flowchart sequentially showing a method of manufacturing a display device according to another embodiment. FIG. 10 is a schematic cross-sectional view of the display device manufactured by using the method of manufacturing the display device of FIG. 8 according to another embodiment.

Referring to FIGS. 9 and 10, the method of manufacturing the display device according to an embodiment includes an operation (S210 of FIG. 7) of forming an emission device 220 on a substrate 210. The method also includes an operation of forming a thin film encapsulation layer 230 including at least one of inorganic films 231, 233, and 235, and at least one of organic films 232 and 234 on the emission device 220 and inspecting surfaces of the inorganic films 231, 233, and 235 or the organic films 232 and 234.

According to an embodiment, the operation of forming the thin film encapsulation layer 230 and inspecting the surfaces of the inorganic films 231, 233, and 235 and the surfaces of the organic films 232 and 234 includes an operation (S220 of FIG. 7) of forming the first inorganic film 231 on the emission device 220. The operation also includes an operation (S230 of FIG. 7) of forming the first organic film 232 on the first inorganic film 231, an operation (S240 of FIG. 7) of inspecting the surface of the first organic film 232, and an operation (S250 of FIG. 7) of forming the second inorganic film 233 on the first organic film 232. The operation further includes an operation S260 of forming the second organic film 234 on the second inorganic film 233, an operation S270 of inspecting the surface of the second organic film 234, and an operation S280 of forming the third inorganic film 235 on the second organic film 234.

According to an embodiment, the first inorganic film 231 can include a single layer or a multiple layer formed of SiNₓ, SiO₂, SiOₓN_{y}, or Al₂O₃. The first inorganic film 231 can be formed by using sputtering or chemical vapor deposition (CVD).

A capping layer 241 performing a function of improving a characteristic of the light emitted from the emission device 220 and/or a cover layer 242 improving the characteristic of the light emitted from the emission device 220 and protecting the emission device 220 from a damage during a process using plasma can be further formed between the first inorganic film 231 and the emission device 220. The cover layer 242 according to an embodiment is formed of LiF.

After the operation S220 of forming the first inorganic film 231 is performed, the operation S230 of forming the first organic film 232 on the first inorganic film 231, the operation S240 of inspecting the surface of the first organic film 232, and the operation S250 of forming the second inorganic film 233 on the first organic film 232 can be performed. That is, the operations S210 through S250 are the same as the method of manufacturing the display device of FIG. 7, and thus the operations are not shown in FIG. 9. Additional operations included in the method of manufacturing the display device according to an embodiment will be described below.

After the second inorganic film 233 is formed, the operation S260 of forming the second organic film 234 on the second inorganic film 233, and the operation S270 of inspecting the surface of the second organic film 234 can be performed. According to an embodiment, the second organic film 234 is formed of various types of organic materials such as epoxy based resin, acryl based resin, or polyimide based resin, etc.

Although a top surface of the second organic film 234 can be substantially flat, due to various factors that can occur during a process, an undesired defect such as a protruding unit and/or a sunken unit can occur in the top surface of the second organic film 234, like the first organic film 232. When a height or depth of a protruding or sunken unit is extremely large, the protruding or sunken unit can be a defect of the display device. Thus, whenever an organic film is formed, a surface shape of the organic film is measured, thereby determining whether the defect occurs.

The operation S270 of inspecting the surface of the second organic film 234 is the same as the operation S240 of inspecting the surface of the first organic film 232, and thus a detailed description thereof is omitted below.

The operation S280 of forming the third inorganic film 235 on the second organic film 234 can be performed after the operation S270 of inspecting the surface of the second organic film 234 is performed. According to an embodiment, the third inorganic film 235 can include a single layer including SiNₓ, SiO₂, or SiOₓN_{y}.

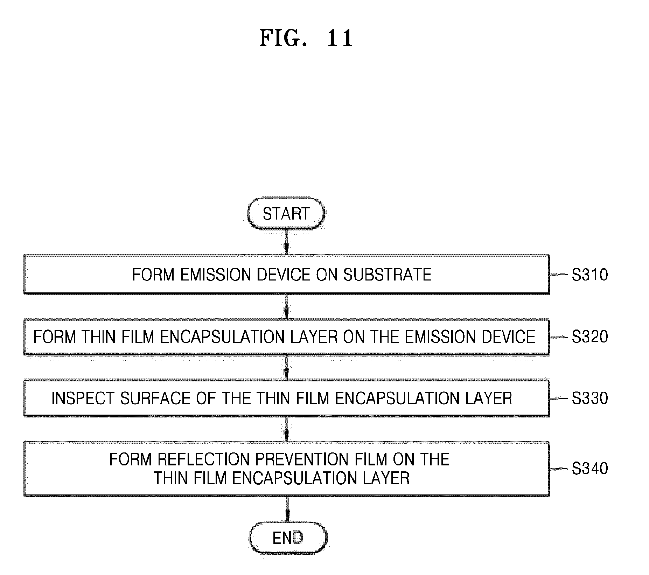

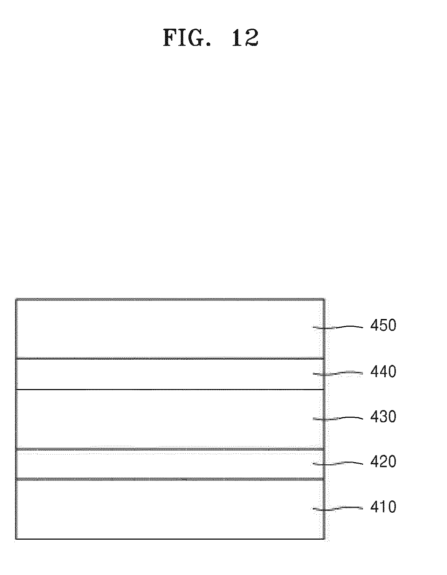

FIG. 11 is a flowchart sequentially showing a method of manufacturing a display device according to another embodiment. FIG. 12 is a schematic cross-sectional view of the display device manufactured by using the method of manufacturing the display device of FIG. 11 according to another embodiment.

Referring to FIGS. 11 and 12, the method of manufacturing the display device according to an embodiment includes an operation S310 of forming an emission device 420 on a substrate 410, an operation S320 of forming a thin film encapsulation layer 430 including at least one inorganic film and at least one organic film on the emission device 420, and an operation S330 of inspecting a surface of the thin film encapsulation layer 430. Depending on the embodiment, additional states can be added, others removed, or the order of the states changed in FIG. 11.

The method of manufacturing the display device of FIGS. 7 and 9 performs a surface inspection whenever the organic films 132, 232, and 234 are formed during a process of forming the thin film encapsulation layers 130 and 230, whereas the method of manufacturing the display device of FIG. 11 can measure a shape of an uppermost surface of the thin film encapsulation layer 430 after forming the thin film encapsulation layer 430.

The thin film encapsulation layer 430 can include at least one inorganic film and organic film. The numbers of inorganic film and organic film can vary. The uppermost layer of the thin film encapsulation layer 430 can be an inorganic film but is not limited thereto.

After the thin film encapsulation layer 430 is formed, when a surface of the thin film encapsulation layer 430 is measured, the shape of the uppermost surface can be measured by overlapping thickness defects of films included in the thin film encapsulation layer 430. Such a measurement can be used to determine a defect of the thin film encapsulation layer 430, i.e., a defect of the display device.

According to an embodiment, after the operation S330 of inspecting the surface of the thin film encapsulation layer 430 is performed, an operation S340 of forming a reflection prevention film 450 on the thin film encapsulation layer 430 is further performed. To improve visibility by preventing an external reflection of the display device, the reflection prevention film 450 can be formed in the display device, and can include a polarizer (not shown) and a retarder. An adhesive member 440 can be placed between the thin film encapsulation layer 430 and the reflection prevention film 450.

When the defect is confirmed by performing the surface inspection on the thin film encapsulation layer 430, the display device that is being manufactured can be discarded without attaching an optical device such as the polarizer (not shown) that is relatively highly expensive, and thus it is economical.

As described above, according to one or more exemplary embodiments, surface inspection apparatus and method, and a method of manufacturing a display device using the surface inspecting apparatus and method precisely measures a shape of a surface having a large area throughout an entire area.

It is clear for a person skilled in the art that the disclosed embodiments can also be combined where possible.

## Claims

1. A surface inspection method for a display device, comprising:
Placing (S100) an object (10) on a stage (100) comprising a top surface inclined at a predetermined angle (θ) with respect to a plane having a first direction (X) and a second direction (Y) crossing the first direction (X);
irradiating light (S120) onto the object (10) via a surface inspection unit (300) including i) an interferometer (320) having an optical axis (OA) aligned in a third direction (Z) crossing the plane and ii) an imaging device (310) receiving an interference light formed by the interferometer (320);
obtaining a first image (S130) comprising first interference fringes captured by the imaging device (310);
moving (S140) at least one of the surface inspection unit (300) and the stage (100) in at least one of the first and second directions (X,Y);
obtaining (S150) a second image comprising second interference fringes captured by the imaging device (310); and
moving (S170) the surface inspection unit (300) in the third direction (Z) so as to correct movement of the second interference fringes with respect to the first interference fringes.

2. The surface inspection method of claim 1, further comprising, after placing the object (10), aligning (S110) the surface inspection unit (300) such that a focal point of the irradiated light is located on the object (10).

3. The surface inspection method of claim 1 or 2, further comprising, after obtaining the second image,
detecting and storing (S160) changes in at least one of spaces and shapes of the second interference fringes with respect to the first interference fringes; and
reconstructing (S190) a surface shape of the object corresponding to the changes.

4. The surface inspection method of one of the preceding claims, wherein the top surface of the stage (100) is inclined from 0.8 degrees to 16 degrees with respect to the plane.

5. The surface inspection method of one of the preceding claims, wherein the moving (S170) comprises:
counting the number of the first and second interference fringes (S171); and
moving the surface inspection unit in the third direction (Z) such that the number of the second interference fringes is the same as that of the first interference fringes (S172).

6. The surface inspection method of one of the preceding claims, wherein the moving (S170) comprises moving the surface inspection unit (300) in the third direction (Z) with a piezoelectric element.

7. The surface inspection method of one of the preceding claims, wherein the interferometer (320) comprises:
a light source (321) configured to emit light;
a reference mirror (322);
a beam splitter (323) configured to split the emitted light into first light to be directed towards the object (10) and second light to be directed towards the reference mirror (322); and
a focusing lens (342) placed on a path of the first light,
wherein the irradiating (S120) comprises focusing the emitted light on the object (10).

8. A surface inspection apparatus for a display device, comprising:
a stage (100) configured to support an object (10) and having a top surface (101) inclined at a predetermined angle with respect to a plane having a first direction (X) and a second direction (Y) crossing the first direction (X);
a surface inspection unit (300) comprising i) an interferometer (320) having an optical axis aligned in a third direction (Z) crossing the plane and configured to emit interference light and ii) an imaging device (310) configured to receive the interference light from the interferometer (320);
a horizontal driver (500) configured to move at least one of the surface inspection unit (300) and the stage (100) in at least one of the first and second directions (X, Y);
a perpendicular driver (700) configured to move the surface inspection unit (300) in the third direction (Z); and
a controller (900) configured to control the horizontal driver (500) and the perpendicular driver(700).

9. The surface inspection apparatus of claim 8, wherein the top surface (101) is inclined from 0.8 degrees to 16 degrees with respect to the plane.

10. The surface inspection apparatus of claim 8 or 9,
wherein the imaging device (310) is further configured to move at least one of the surface inspection unit (300) and the stage (100) with the use of the horizontal driver (500) and obtain images including interference fringes, and
wherein the controller (900) is further configured to control the perpendicular driver (700) to correct movement of the interference fringes and move the surface inspection unit (300) in the third direction (Z).

11. The surface inspection apparatus of one of claims 8 to 10, wherein the controller (900) comprises a calculator (930) configured to count the number of interference fringes included in the images.

12. The surface inspection apparatus of claim 11, wherein the controller (900) is further configured to control the perpendicular driver(700) to maintain the number of the calculated interference fringes to be substantially constant and move the surface inspection unit (300) in the third direction.

13. The surface inspection apparatus of one of claims 8 to 12, wherein the perpendicular driver (700) comprises a piezoelectric element.

14. The surface inspection apparatus of one of claims 8 to 13, wherein the interferometer (320) comprises:
a light source (321) configured to emit light;
a reference mirror (322);
a beam splitter (323) configured to split the emitted light into first light to be directed towards the object (10) and second light to be directed towards the reference mirror (322); and
a focusing lens (324) placed on a path of the first light and configured to focus the emitted light.

15. The surface inspection apparatus of claim 14, wherein the light source is configured to emit white light.
